# EUROPÄISCHE PATENTSCHRIFT

(11) **EP 1 456 683 B1**
(45) Veröffentlichungstag und Bekanntmachung des Hinweises auf die Patenterteilung: **20.07.2005**
(21) Anmeldenummer: 02792968.6
(22) Anmeldetag: 11.12.2002
(51) Int. Cl.: G01R 35/04, G01R 22/00

(54) **EINRICHTUNG ZUR MESSUNG DES VERBRAUCHS ELEKTRISCHER ENERGIE**
DEVICE FOR MEASURING THE CONSUMPTION OF ELECTRICAL ENERGY
DISPOSITIF DE MESURE DE LA CONSOMMATION D'ELECTRICITE

(30) Priorität: 18.12.2001 DE 10162259
(43) Veröffentlichungstag der Anmeldung: 15.09.2004
(73) Patentinhaber: Austriamicrosystems AG, 8141 Unterpremstätten (AT)
(72) Erfinder: SCHMALZL, Erwin, A-8010 Graz (AT); FRITZ, Gerhard, A-8020 Graz (AT)
(74) Vertreter: Epping, Hermann, Fischer
(86) Internationale Anmeldenummer: PCT/EP2002/014076
(87) Internationale Veröffentlichungsnummer: WO 2003/052447

(56) Entgegenhaltungen:
- DE-A- 19 842 241
- US-A- 4 884 021
- US-A- 5 736 848

## Beschreibung

Die vorliegende Erfindung betrifft Einrichtung zur Messung des Verbrauchs elektrischer Energie.

Meßeinrichtungen oder Energiezähler für elektrische Energie, welche umgangssprachlich auch als Stromzähler oder Kilowattstunden-Zähler (kWh-Zähler) bezeichnet werden, dienen zur Erfassung von in ein elektrisches Netz eingespeister oder aus einem elektrischen Netz bezogener elektrischer Energie. Hierfür wird die aus dem elektrischen Netz beispielsweise von einem Verbraucher bezogene, elektrische Momentanleistung über die Zeit integriert. Die momentane elektrische Leistung ergibt sich dabei aus dem Produkt des Stroms und der Spannung. Derartige, elektrische Energiezähler dienen den elektrischen Energieversorgungsunternehmen, EVU, als Abrechnungsgrundlage gegenüber ihren Kunden, den Verbrauchern.

In der Druckschrift DE 198 42 241 A1 ist ein Elektrizitätszähler angegeben. Dieser umfaßt einen integrierten Eingangsbaustein mit Analog/Digital-Wandler sowie ein Multipliziermittel. Außerdem sind Eingänge zum Zuführen von Spannung und Strom vorgesehen. Es ist weiter vorgesehen, bei der Herstellung des Zählers Abgleichinformationen zu hinterlegen.

Um die Kosten für den Bezug elektrischer Energie zu reduzieren, besteht seitens der Verbraucher die Versuchung, elektrische Energiezähler so zu manipulieren, daß eine geringere als die tatsächlich bezogene elektrische Energie angezeigt wird. Zum Schutz vor unerwünschten, derartigen manipulatorischen Angriffen bringen die EVU beispielsweise Verplombungen an den Energiezählern an. Diese haben jedoch nur eine begrenzte Schutzwirkung.

Insbesondere bei modernen, digital arbeitenden und auf Halbleiterbasis hergestellten elektrischen Energiezählern könnte eine Manipulation der Energiezählung durch Umprogrammieren der beteiligten elektronischen Bauelemente versucht werden.

Aufgabe der vorliegenden Erfindung ist es, eine Einrichtung - zur Messung des Verbrauchs elektrischer Energie anzugeben, welche zum Einen auf einem Chip integrierbar ist und bei der zum Anderen der Schutz vor einer unerwünschten Manipulationen mit dem Ziel, die gezählte gegenüber der tatsächlich bezogenen Energiemenge zu verringern, verbessert ist.

Erfindungsgemäß wird die Aufgabe gelöst durch eine Einrichtung zur Messung des Verbrauchs elektrischer Energie, aufweisend
- einen ersten Eingang zum Zuführen eines Spannungssignals,
- einen zweiten Eingang zum Zuführen eines Stromsignals,
- einen Multiplizierer, der mit erstem und zweitem Eingang gekoppelt ist und in Abhängigkeit von Spannungs- und Stromsignal an seinem Ausgang ein Zwischensignal abgibt,
- einen Kalibrierblock, der mit dem Ausgang des Multiplizierers und mit einem nichtflüchtigen Speicher gekoppelt ist und das Zwischensignal des Multiplizierers mit einem Kalibrierfaktor multipliziert,
- einen Integrator, der mit dem Kalibrierblock gekoppelt ist und an seinem Ausgang einen kalibrierten Energiemeßwert bereitstellt und
- den nichtflüchtigen Speicher, der zum Ablegen des Kalibrierfaktors eine Vielzahl von irreversibel programmierbaren Speicherzellen umfaßt, derart, daß ein Umprogrammieren einer beliebigen Speicherzelle eine Erhöhung des Kalibrierfaktors bewirkt.

Die Meßeinrichtung ist im folgenden auch als Zählerschaltung bezeichnet.

Gemäß dem vorgestellten Prinzip werden elektrische Spannung und elektrischer Strom bevorzugt als zeit- und wertkontinuierliche Analogsignale der Zählerschaltung an erstem und zweitem Eingang zugeführt. Mittels des Multiplizierers wird die momentan bezogene elektrische Leistung durch Multiplikation von Spannung und Strom ermittelt. In dem nachgeschalteten Kalibrierblock wird die ermittelte elektrische Leistung mit einem Kalibrierfaktor multipliziert und schließlich wird aus dem derart gewonnenen, kalibrierten Momentanleistungswert ein Energiemeßwert durch Integration über die Zeit oder durch Akkumulieren einer endlichen Zahl von Leistungsmeßwerten gebildet.

Die Kalibrierung eines elektrischen Energiezählers ist vorteilhaft, da auf Grund von fertigungsbedingten Parameterschwankungen, welche Bauelementwerttoleranzen zur Folge haben, sowie auf Grund von alterungsbedingten Drifteffekten und anderen Ursachen für Normabweichungen Meßfehler auftreten könnten, welche unerwünscht wären.

Gemäß dem vorliegenden Prinzip ist der nichtflüchtige Speicher, der zum Ablegen des Kalibrierfaktors vorgesehen ist, so ausgeführt, daß ein nachträgliches Umprogrammieren einer beliebigen Speicherzelle, die vom nichtflüchtigen Speicher umfaßt ist, eine Erhöhung des Kalibrierfaktors bewirkt. Die einzelnen programmierbaren Speicherzellen sind dabei irreversibel programmierbar. Derartige, irreversibel programmierbare Speicherzellen sind beispielsweise als Schmelzsicherungen, sogenannte Fuses, sowie als programmierbare Dioden bekannt, die man durch Überlastung in Sperrichtung in einen Kurzschluß umwandeln kann, sogenanntes Zenerzapping.

Neben den genannten Bauelementen können selbstverständlich auch andere programmierbare Zellen eingesetzt werden.

Abhängig von der Bauart-der verwendeten, programmierbaren Speicherzellen wird der im nichtflüchtigen Speicher abzulegende Kalibrierfaktor gemäß dem vorliegenden Prinzip so codiert, daß bei nachträglichem Umprogrammieren der Speicherzellen, unabhängig davon, welche Auswahl von programmierbaren Speicherzellen umprogrammiert wird, stets eine Erhöhung des Kalibrierfaktors bewirkt ist.

Somit ist sichergestellt, daß es bei einem unerwünschten Angriff auf die Zählerschaltung mit dem Ziel, diese so zu manipulieren, daß der Zählwert bezüglich der real bezogenen elektrischen Energie geringer ist, stets zu einer Erhöhung der gemessenen Energiemenge bezüglich der real abgegebenen Energiemenge kommt.

Eine Erhöhung des Kalibrierfaktors durch nachträgliches Umprogrammieren der Speicherzellen führt demnach dazu, daß der elektrische Zähler mehr Kilowattstunden zählt als tatsächlich bezogen, keinesfalls weniger.

Ein Kalibrierfaktor kann beispielsweise während oder unmittelbar nach der Fertigung oder im Rahmen einer amtlichen Eichung der Zählerschaltung programmiert werden.

Gemäß einer bevorzugten Ausführungsform der vorliegenden Erfindung umfaßt der nichtflüchtige Speicher einen Programmiereingang zum Programmieren der Speicherzellen. Die Programmierung der Speicherzellen kann beispielsweise mit einem parallelen oder seriellen Programmiereingang eines programmierbaren Festwertspeichers durchgeführt werden. Wie bei derartigen Speichern üblich, kann die Adressierung der einzelnen Speicherzellen beispielsweise mittels Zeilen- und Spaltendecodern erfolgen. Dabei sind die programmierbaren Speicherzellen matrixförmig, beispielsweise in einer quadratischen Matrix, angeordnet.

Gemäß einer weiteren, bevorzugten Ausführungsform der vorliegenden Erfindung umfassen die programmierbaren Speicherzellen je eine Diode, welche durch Beaufschlagen mit einem Energieimpuls irreversibel in einen niederohmigen Zustand übergeht.

Derartige, programmierbare Festwertspeicher, die man durch Überlastung in Sperrichtung von einem elektrisch hochohmigen Zustand in einen elektrischen Kurzschluß umwandeln kann, werden auch als Anti-Fuses bezeichnet. Bei Verwendung derartiger, programmierbarer Speicherzellen sind gemäß vorliegendem Prinzip bevorzugt zunächst alle programmierbaren Speicherzellen in einem hochohmigen Zustand. Gemäß dem vorliegenden Prinzip wird der kleinste einstellbare Kalibrierfaktor beispielsweise dadurch codiert, daß sich alle programmierbaren Speicherzellen im hochohmigen Leitzustand befinden und der größte einstellbare Kalibrierfaktor wird dadurch codiert, daß sich alle programmierbaren Speicherzellen in einem niederohmigen Leitzustand befinden. Durch Umprogrammieren in einem irreversiblen Vorgang vom hochohmigen in den niederohmigen Leitzustand kann demnach der Kalibrierfaktor lediglich erhöht, nicht jedoch verringert werden. Dabei ist es gemäß vorliegendem Prinzip unerheblich, ob lediglich eine, eine bestimmte Auswahl oder alle der programmierbaren Speicherzellen umprogrammiert werden.

In einer alternativen, ebenfalls bevorzugten Ausführungsform der vorliegenden Erfindung umfassen die programmierbaren Speicherzellen je eine Schmelzsicherung, welche durch Beaufschlagen mit einem Energieimpuls irreversibel von einem niederohmigen in einen hochohmigen Leitzustand übergeht. Derartige Schmelzsicherungen werden auch als Fuses bezeichnet, welche üblicherweise durch dünne Metallisierungsbrücken ausgebildet sind. Diese werden durch Beaufschlagen mit einem Energieimpuls, beispielsweise einem Strom- oder Spannungsimpuls, irreversibel von einem sehr niederohmigen in einen praktisch unendlich hochohmigen Leitzustand überführt. Bezüglich der Codierung des Kalibrierfaktors gilt demnach, daß beispielsweise der kleinste einstellbare Kalibrierfaktor codiert wird dadurch, daß sich alle Schmelzsicherungen im niederohmigen Leitzustand befinden und der größte einstellbare Kalibrierfaktor beispielsweise dadurch codiert wird, daß sich alle Schmelzsicherungen oder programmierbaren Speicherzellen in einem hochohmigen Leitzustand befinden. Gemäß vorliegender Erfindung ist bei der Codierung des Kalibrierfaktors demnach darauf zu achten, daß durch irreversibles Überführen einer beliebigen Speicherzelle oder einer beliebigen Auswahl von Speicherzellen vom niederohmigen in den hochohmigen Leitzustand stets eine Vergrößerung des Kalibrierfaktors bewirkt ist.

Gemäß einer weiteren, bevorzugten Ausführungsform der vorliegenden Erfindung ist am Ausgang des Integrators ein Pulsgenerator angeschlossen, der proportional zum am Ausgang des Integrators bereitgestellten, kalibrierten Energiemeßwert ein codiertes Ausgangssignal bereitstellt.

Das codierte Ausgangssignal des Pulsgenerators ist demnach ein Maß für die von der Zählerschaltung gemessene, elektrische Energie, beispielsweise seit einem Zurücksetzen des Energie-Meßwertes im Integrator.

Gemäß einer weiteren, bevorzugten Ausführungsform der vorliegenden Erfindung sind zur Kopplung von erstem und zweitem Eingang mit dem Multiplizierer je ein Analog-/Digital-Wandler vorgesehen.

Der mit dem ersten Eingang der Zählerschaltung gekoppelte Analog-/Digital-Wandler konvertiert demnach ein analog eingespeistes Spannungssignal in ein digitales Spannungssignal, welches bevorzugt zeit- und wertdiskret oder zumindest wertdiskret vorliegt.

Entsprechend konvertiert der mit dem zweiten Eingang der Zählerschaltung gekoppelte Analog-/Digital(A/D)-Wandler das eingansseitig zuführbare Stromsignal, welches als Analogsignal vorliegt, in ein digitales Signal, welches zumindest wertdiskret und bevorzugt zeit- und wertdiskret vorliegt. Abgesehen von einem Quantisierungsfehler, welcher unvermeidlich ist, sind die ausgangsseitig an den A/D- Wandlern ableitbaren, digitalen Strom- und Spannungssignale proportional zu den eingangsseitig zugeführten, analogen Strom- und Spannungssignalen. Die A/D-Wandler ermöglichen eine schnelle, störurigsunanfällige und zuverlässig arbeitende digitale Signalverarbeitung der Strom- und Spannungssignale, insbesondere deren Multiplikation zu einem Momentanleistungswert sowie die Multiplikation mit dem Kalibrierfaktor und schließlich das Akkumulieren der ermittelten, kalibrierten Leistungswerte im Integrator.

Gemäß einer weiteren, bevorzugten Ausführungsform der vorliegenden Erfindung ist zur Kopplung von A/D-Wandlern und dem Multiplizierer je ein Digitalfilter vorgesehen, welches eingangsseitig mit einem Ausgang des jeweiligen Analog-/DigitalWandlers und ausgangsseitig mit je einem Eingang des Multiplizierers verbunden ist.

Die Digitalfilter ermöglichen mit Vorteil insbesondere ein Unterdrücken von bei der Quantisierung in den A/D-Wandlern entstehenden, höheren Harmonischen der Signale, die in den nachgeschalteten Multiplizierern zu verfälschungen des Meßergebnisses führen könnten.

Gemäß einer weiteren, bevorzugten Ausführungsform der vorliegenden Erfindung ist der nichtflüchtige Speicher ausgelegt zum Ablegen des Kalibrierfaktors in binär codierter Weise.

Da die Speicherzellen von programmierbaren Festwertspeichern in Abhängigkeit von ihrem Leitzustand üblicherweise lediglich zwei logische Zustände annehmen können, der entweder hochohmig oder niederohmig ist, ist die Binärcodierung besonders geeignet zur Codierung des Kalibrierfaktors mittels Festwertspeichern.

Gemäß einer weiteren, bevorzugten Ausführungsform der vorliegenden Erfindung ist die Zählerschaltung als integrierte, elektronische Schaltung ausgebildet.

Gemäß einer weiteren, bevorzugten Weiterbildung der Zählerschaltung ist der nichtflüchtige Speicher so ausgebildet, daß der am nichtflüchtigen Speicher ableitbare Kalibrierwert ausschließlich positive Werte annehmen kann.

Der Kalibrierwert wird demnach im nichtflüchtigen Speicher vorzeichenlos abgelegt. Die Kalibrierwerte können hierbei Werte aus einem Wertebereich annehmen, beispielsweise zwischen 0,5 und 2, welche dann mit dem gemessenen Momentanleistungswert multipliziert werden.

Weitere Einzelheiten und vorteilhafte Ausgestaltung der Erfindung sind Gegenstand der Unteransprüche.

Die Erfindung wird nachfolgend an einem Ausführungsbeispiel anhand der Zeichnungen näher erläutert.

Es zeigen:
- Figur 1: ein vereinfachtes Blockschaltbild einer ersten, beispielhaften Ausführungsform der erfindungsgemäßen Zählerschaltung anhand ausgewählter Schaltungsblöcke, und
- Figur 2: die beispielhafte Codierung des Kalibrierfaktors im nichtflüchtigen Speicher bei einer Zählerschaltung gemäß Figur 1 anhand ausgewählter Kalibrierwerte.

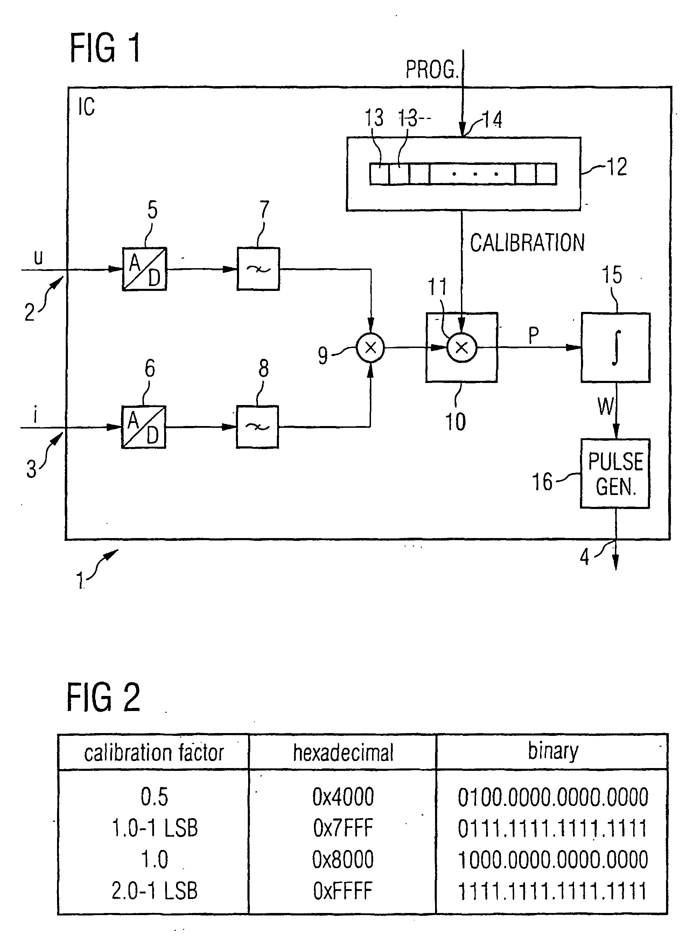

Figur 1 zeigt ein Blockschaltbild einer als integrierter Schaltkreis auf einem Chip 1 aufgebauten Zählerschaltung für elektrische Energie. Diese weist einen ersten Eingang 2 zum Zuführen eines Spannungssignals u, einen zweiten Eingang 3 zum Zuführen eines Stromsignals i sowie einen Ausgang 4 auf, an dem ein kalibrierter Meßwert ableitbär ist, der ein Maß für eine von Strom- und Spannungssignal i, u abhängige und über eine bestimmte Zeit hinweg integrierte elektrische Energiemenge ist.

Im einzelnen umfaßt die Zählerschaltung zwei Analog-/Digital-Wandler 5, 6, mit je einem Eingang zum Zuführen eines Analogsignals, die mit erstem bzw. zweitem Eingang 2, 3 der Zählerschaltung verbunden sind. Ausgangsseitig an den Analog/Digital-Wandlern 5, 6 ist je ein digitales Filter 7, 8 angeschlossen. Die Ausgänge der digitalen Filter 7, 8 sind mit je einem Eingang eines digital arbeitenden Multiplizierers 9 verbunden. Der Multiplizierer 9 stellt an seinem Ausgang ein durch Multiplikation von Strom- und Spannungssignal i, u gebildetes Zwischensignal bereit, welches ein Maß für die momentane elektrische Leistung, jedoch nicht kalibriert, ist. Der Ausgang des Mischers 9 ist mit einem Kalibrierblock 10 verbunden. Der Kalibrierblock 10 weist einen weiteren Multiplizierer 11 mit zwei Eingängen auf, von denen ein erster Eingang mit dem Ausgang des Multiplizierers 9 und ein zweiter Eingang mit einem nichtflüchtigen Speicher 12 verbunden ist. Der nichtflüchtige Speicher 12 umfaßt eine Vielzahl von irreversibel programmierbaren Speicherzellen 13. Weiterhin umfaßt der nichtflüchtige Speicher 12 einen Programmiereingang 14 zum Programmieren der irreversibel programmierbaren Speicherzellen 13. Der Ausgang des weiteren Multiplizierers 11 im Kalibrierblock 10, an dem ein kalibriertes Signal bereitgestellt ist, welches die momentane elektrische Leistung P repräsentiert, ist an den Eingang eines Integrators 15 angeschlossen, der die momentane elektrische Leistung P über die Zeit integriert und an seinem Ausgang einen Energiezählwert W bereitstellt. Der Ausgang des Integrators 15 ist mit dem Eingang eines Pulsgenerators 16 verbunden, der an seinem Ausgang 4 den aktuellen EnergieMeßwert des Zählers bereitstellt.

Mit dem auf einem Chip integrierten elektrischen Energiezähler gemäß Figur 1 wird ständig die aktuelle elektrische Leistung erfaßt, welche sich durch das Produkt aus Spannungssignal u und Stromsignal i ergibt. Die Spannung u ist dabei üblicherweise die Nennspannung eines elektrischen versorgungsnetzes, beispielsweise 230 Volt Wechselstrom. Die aus Spannungs- und Stromsignal abgeleitete aktuelle elektrische Leistung wird am Ausgang des Multiplizierers 9 bereitgestellt. Mit dem Kalibrierblock 10 wird die elektrische Leistung, die am Ausgang des Multiplizierers 9 bereitgestellt wird, mit einem Kalibrierfaktor multipliziert. Dieser Kalibrierfaktor dient zur Korrektur von Norm-Abweichungen sowohl intern auf dem die Zählerschaltung 1 tragenden Chip sowie auch extern, beispielsweise verursacht durch Leitungsimpedanzen. Der Kalibrierfaktor wird beispielsweise nach einer Fertigung der Zählerschaltung während einer Eichung oder Kalibrierung des elektrischen Energiezählers ermittelt. Der Kalibrierfaktor wird nun ständig mit der aktuellen, elektrischen Leistung multipliziert, derart, daß am Ausgang des Kalibrierblocks 10 eine um den Kalibrierfaktor korrigierte, elektrische Momentanleistung P bereit steht. Diese korrigierte, elektrische momentane Leistung P wird im Integrator 15 ständig akkumuliert. Mittels des Kalibrierfaktors werden demnach insbesondere fertigungsbedingte Normabweichungen von Bauelementwerten der integrierten Zählerschaltung 1 kompensiert. Hierdurch wird das Ergebnis der Energiezählung, nämlich der am Ausgang des Integrators 15 bereitgestellte, akkumulierte Energiemeßwert bezüglich seiner Genauigkeit deutlich verbessert. Der Kalibrierfaktor ist dabei derart im nicht-flüchtigen Speicher 12 abgelegt, daß ein nachträgliches Verändern von Bits, das heißt ein Umprogrammieren einzelner programmierbarer Speicherzellen unabhängig von der Auswahl der umprogrammierten Speicherzelle stets zu einer Vergrößerung des Kalibrierfaktors führt und damit auch zu einer Erhöhung der elektrischen Momentanleistung, so daß eine Manipulation des Energiezählers für den Manipulierenden nicht vorteilhaft ist.

Der nicht-flüchtige Speicher 12 umfaßt eine Vielzahl von in einer Matrix angeordneten, irreversibel programmierbaren Speicherzellen. Jede der programmierbaren Speicherzellen kann einen von zwei möglichen Zuständen, null oder eins, annehmen. Es ist eine Eigenschaft eines nicht-flüchtigen Speichers, daß die programmierten Zustände der programmierbaren Speicherzellen auch dann beibehalten werden, wenn eine Versorgungsspannung der Zählerschaltung abgestellt wird. Die programmierbaren Speicherzellen sind irreversibel programmierbar, das heißt ihr Speicherzustand, der üblicherweise in Form eines elektrischen Leitzustandes vorliegt, kann lediglich in eine Richtung, beispielsweise von hochohmig nach niederohmig oder von niederohmig nach hochohmig umprogrammiert werden. Derartige, nicht-flüchtige und irreversibel programmierbare Speicherzellen werden auch als Fuses oder Anti-Fuses, je nach Ausführung, bezeichnet. Die programmierbaren Speicherzellen 13 sind im vorliegenden Ausführungsbeispiel als Dioden realisiert, welche durch Überlastung in Sperrichtung in einen Kurzschluß umgewandelt werden können. Alternativ können jedoch auch andere programmierbare Speicherzellen, beispielsweise Floating-Gate-Mosfets, die sich ebenfalls als PROM, Programmable Read-Only Memory eignen, einsetzbar. Beim Programmierbaren derartiger Floating-Gate-Mosfets wird das isölierte Floating-Gate beim Programmieren aufgeladen, so daß sich die Schwellenspannung des Mosfets dauerhaft verschiebt.

Figur 2 zeigt anhand eines Ausführungsbeispiels das Codieren des Kalibrierfaktors in dem nicht-flüchtigen Speicher 12, der hier.16 programmierbare Speicherzellen umfaßt. Ausgangszustand der programmierbaren Speicherzellen ist eine logische Null, der bei der hier vorgesehenen Verwendung von Dioden einen hochohmigen Leitzustand repräsentiert. Bei der Tabelle gemäß Figur 2 ist in einer ersten Spalte der Kalibrierfaktor dezimal dargestellt, in einer zweiten Spalte hexadezimal und in einer dritten Spalte binäre codiert angegeben, jeweils für vier Beispielwerte, nämlich für den Kalibrierfaktor 0,5; 1,0-1 LSB; 1,0 und 2,0 - 1 LSB. LSB bezeichnet dabei das geringwertigste Bit, das sogenannte Least Significant Bit. Die vorliegende Tabelle zeigt demnach einen Kalibrierfaktor, der in einem Bereich von 0,5 bis 2,0 einstellbar ist. Dieser Kalibrierfaktor wird, wie bereits anhand der Beschreibung von Figur 1 erläutert, ständig mit dem aktuell ermittelten Momentanleistungswert multipliziert. Selbstverständlich können in praktischen Realisierungen eine Vielzahl weiterer Kalibrierfaktoren codierbar sein. Figur 2 zeigt anhand der Tabelle lediglich eine Auswahl der Kalibrierfaktoren.

Die binäre Codierung ohne Vorzeichenbit ermöglicht eine einfache Multiplikation. Im vorliegenden Beispiel, bei dem der größte einstellbare Kalibrierfaktor 2,0 - 1 LSB beträgt, ist der Dezimalpunkt der binären Codierung zwischen den beiden höchstwertigen Bits vorgesehen. Beispielsweise würde die binär codierte Zahl 1100 die Dezimalzahl 1,5 bezeichnen, die binär codierte Zahl 1010 bezeichnet die Dezimalzahl 1,25 usw.

Bei der Binärdarstellung gemäß Figur 2 entspricht eine logische Null dem Ausgangszustand der irreversibel programmierbaren Speicherzelle, während eine logische Eins denjenigen Zustand angibt, den die Speicherzelle nach einem Durchführen einer irreversiblen Zustandsänderung, das heißt nach einem Umprogrammieren hat. Man erkennt, daß bei der Binärcodierung gemäß der Tabelle von Figur 2 ein beliebiges Umprogrammieren einer oder mehrerer Speicherzellen, also im vorliegenden Fall der Zustandsübergang von einer Null zu einer Eins, stets zu einer Erhöhung des Kalibrierfaktors führt.

Anhand eines weiteren Codierungsbeispiels mit Vier-Bit-Binärdarstellung soll das vorliegende Prinzip noch weiter verdeutlicht werden. Man nehme an, der Ursprungszustand des nichtflüchtigen Speichers zum Ablegen des Kalibrierfaktors sei 0000. Da wiederum zwischen den linken beiden, das heißt zwischen den beiden höchstwertigen Bits die Komma-Stelle der Dezimalzahl dargestellt sein soll, bedeutet die Bitfolge 1000 die Dezimalzahl 1.0, so daß die 1 programmiert werden muß. Wenn irgend ein beliebiges, weiteres Bit verändert wird, im Rahmen beispielsweise eines Manipulationsversuches, beispielsweise das zweite Bit, so ist der neue, binär dargestellte Kalibrierfaktor 1010, was die Dezimalzahl 1,25 darstellt. Man erkennt, daß der Kalibrierfaktor zugenommen hat.

Alternativ zu der vorgestellten, binären Codierung des Kalibrierfaktors könnte man auch davon ausgehen, daß der Ursprungszustand des nicht-flüchtigen Speichers durch das binäre, Vier-Bit-Wort 1111 dargestellt wird und ein Programmieren des Kalibrierfaktors durch Verändern des logischen Zustandes von Eins nach Null erfolgen soll. Demnach würde die logische Eins bei Verwendung einer Diode als programmierbares Element deren hochohmigen Leitzustand repräsentieren. Wenn in diesem Fall bei einer Kalibrierung des Energiezählers als kalibrierfaktor ein Dezimalwert von 1,375 eingestellt werden soll, wäre die Bitfolge 1011 zu programmieren. Hier könnte man nun jedoch beispielsweise das zweite Bit von rechts zu Null machen und hierdurch die Zahl 1001 erhalten, welche der Dezimalzahl 1,125 entspräche. Dieser Kalibrierfaktor wäre jedoch geringer, so daß ein Manipulationsversuch wie vom Angreifer gewünscht zu einer Verringerung der angezeigten Energiemenge führen würde. Eine Manipulation würde damit zu einem Vorteil des manipulierenden führen.

Bei dem alternativen Einsatz eines nichtflüchtigen Speichers, der irreversibel programmierbare Speicherzellen aufweist, bei dem jedoch der Ausgangszustand der programmierbaren Speicherzellen durch logische Einsen dargestellt ist, muß dies bei Anwendung des vorliegenden Prinzips als invertierte Binärzahl betrachtet werden, demnach würde beispielsweise der binär dargestellte Kalibrierfaktor 0111 die Dezimalzahl 1,0 repräsentieren. Wenn hier irgend ein Bit zu Null umprogrammiert wird, wird demnach der Kalibrierfaktor ebenfalls vergrößert. selbstverständlich kann im Rahmen der vorliegenden Erfindung in Analogie zum vorgestellten Einphasenzähler die Zählerschaltung anstelle der gezeigten einphasigen Wechselstromzählerschaltung auch als dreiphasige Zählerschaltung aufgebaut sein.

Weiterhin könnte das beschriebene Prinzip umgekehrt auch zur Meßeinrichtung für das Einspeisen elektrischer Energie in ein Netz, beispielsweise durch den Betreiber einer Windkraft- oder Solarstromanlage, weitergebildet sein, bei dem sich ein Angriff zur Manipulation nicht auf die Verkleinerung, sondern auf die Vergrößerung des Kalibrierfaktors beziehen würde.

## Patentansprüche

1. Einrichtung zur Messung des Verbrauchs elektrischer Energie, aufweisend
- einen ersten Eingang (2) zum Zuführen eines Spannungssignals (u),
- einen zweiten Eingang (3) zum Zuführen eines Stromsignals (i),
- einen Multiplizierer (9), der mit erstem und zweitem Eingang (2, 3) gekoppelt ist und in Abhängigkeit von Spannungs- und Stromsignal (u, i) an seinem Ausgang ein Zwischensignal abgibt,
- einen Kalibrierblock (10), der mit dem Ausgang des Multiplizierers (9) und mit einem nichtflüchtigen Speicher (12) gekoppelt ist und das Zwischensignal des Multiplizierers (9) mit einem Kalibrierfaktor multipliziert,
- einen Integrator (15), der mit dem Kalibrierblock (10) gekoppelt ist und an seinem Ausgang einen kalibrierten Energiemeßwert (W) bereitstellt,
- wobei der nichtflüchtige Speicher (12) zum Ablegen des Kalibrierfaktors eine Vielzahl von irreversibel programmierbaren Speicherzellen (13) umfaßt und derart ausgebildet ist, daß ein Umprogrammieren einer beliebigen Speicherzelle (13) eine Erhöhung des Kalibrierfaktors bewirkt.

2. Einrichtung nach Anspruch 1,
**dadurch gekennzeichnet, daß**
der nichtflüchtige Speicher (12) einen Programmiereingang (14) zum Programmieren-der programmierbaren Speicherzellen (12) umfaßt.

3. Einrichtung nach Anspruch 1 oder 2,
**dadurch gekennzeichnet, daß**
die programmierbaren Speicherzellen (12) je eine Diode umfassen, welche durch Beaufschlagen mit einem Energieimpuls irreversibel von einem hochohmigen in einen niederohmigen Leitzustand übergehen.

4. Einrichtung nach Anspruch 1 oder 2,
**dadurch gekennzeichnet, daß**
die programmierbaren Speicherzellen (12) je eine Schmelzsicherung umfassen, welche durch Beaufschlagen mit einem Energieimpuls irreversibel von einem niederohmigen in einen hochohmigen Leitzustand übergehen.

5. Einrichtung nach einem der Ansprüche 1 bis 4,
**dadurch gekennzeichnet, daß**
am Ausgang des Integrators (15) ein Pulsgenerator (16) angeschlossen ist, der proportional zum kalibrierten Energiemeßwert (W) ein codiertes Ausgangssignal bereitstellt.

6. Einrichtung nach einem der Ansprüche 1 bis 5,
**dadurch gekennzeichnet, daß**
zur Kopplung von erstem und zweitem Eingang (2, 3).mit dem Multiplizierer (9) je ein Analog-/Digital-Wandler (5, 6) vorgesehen ist.

7. Einrichtung nach Anspruch 6,
**dadurch gekennzeichnet, daß**
zur Kopplung der Analog-/Digital-Wandler (5, 6) mit dem Multiplizierer (9) je ein Digitalfilter (7, 8) vorgesehen ist, welches eingansseitig mit einem Ausgang des Analog/Digital-Wandlers (5, 6) und ausgangsseitig mit je einem Eingang des Multiplizierers (9) verbunden ist.

8. Einrichtung nach einem der Ansprüche 1 bis 7,
**dadurch gekennzeichnet, daß**
der nichtflüchtige Speicher (12) ausgelegt ist zum Ablegen des Kalibrierfaktors in binär codierter Form.

9. Einrichtung nach einem der Ansprüche 1 bis 8,
**dadurch gekennzeichnet, daß**
die Einrichtung als integrierte Schaltung ausgeführt ist.

10. Einrichtung nach einem der Ansprüche 1 bis 9,
**dadurch gekennzeichnet, daß**
der nichtflüchtige Speicher (12) derart ausgebildet ist, daß der am nichtflüchtigen Speicher (12) ableitbare Kalibrierfaktor ausschließlich positive Werte annehmen kann.

## Claims

1. Device for measuring the consumption of electrical energy, having
- a first input (2) for the purpose of supplying a voltage signal (u),
- a second input (3) for the purpose of supplying a current signal (i),
- a multiplier (9), which is coupled to the first and the second input (2, 3) and emits an intermediate signal at its output as a function of the voltage and current signal (u, i),
- a calibration block (10), which is coupled to the output of the multiplier (9) and to a non-volatile memory (12) and multiplies the intermediate signal from the multiplier (9) by a calibration factor,
- an integrator (15), which is coupled to the calibration block (10) and provides a calibrated energy measured value (W) at its output,
- the non-volatile memory (12) comprising a large number of irreversibly programmable memory cells (13) for the purpose of storing the calibration factor and being designed such that reprogramming of any desired memory cell (13) brings about an increase in the calibration factor.

2. Device according to Claim 1, **characterized in that** the non-volatile memory (12) comprises a programming input (14) for the purpose of programming the programmable memory cells (12).

3. Device according to Claim 1 or 2, **characterized in that** the programmable memory cells (12) each comprise a diode which switch over irreversibly from a high-resistance conducting state to a low-resistance conducting state by an energy pulse being applied.

4. Device according to Claim 1 or 2, **characterized in that** the programmable memory cells (12) each comprise a fuse which switch over irreversibly from a low-resistance conducting state to a high-resistance conducting state by an energy pulse being applied.

5. Device according to one of Claims 1 to 4, **characterized in that** a pulse generator (16), which provides an encoded output signal proportional to the calibrated energy measured value (W), is connected to the output of the integrator (15).

6. Device according to one of Claims 1 to 5, **characterized in that** in each case an analogue-to-digital converter (5, 6) is provided for the purpose of coupling the first and the second input (2, 3) to the multiplier (9).

7. Device according to Claim 6, **characterized in that** in each case a digital filter (7, 8) is provided for the purpose of coupling the analogue-to-digital converter (5, 6) to the multiplier (9), said digital filter (7, 8) being connected on the input side to an output of the analogue-to-digital converter (5, 6) and on the output side to in each case one input of the multiplier (9).

8. Device according to one of Claims 1 to 7, **characterized in that** the non-volatile memory (12) is designed for the purpose of storing the calibration factor in binary coded form.

9. Device according to one of Claims 1 to 8, **characterized in that** the device is in the form of an integrated circuit.

10. Device according to one of Claims 1 to 9, **characterized in that** the non-volatile memory (12) is designed such that the calibration factor which can be derived at the non-volatile memory (12) can assume exclusively positive values.

## Revendications

1. Dispositif de mesure de la consommation d'énergie électrique, présentant :
- une première entrée (2) pour l'acheminement d'un signal de tension (u),
- une deuxième entrée (3) pour l'acheminement d'un signal de courant (i),
- un multiplicateur (9) qui est couplé à la première et à la deuxième entrée (2, 3) et qui, en fonction du signal de tension et de courant (u, i) émet à sa sortie un signal intermédiaire,
- un bloc de calibrage (10) qui est couplé à la sortie du multiplicateur (9) et est couplé à une mémoire non volatile (12) et multiplie le signal intermédiaire du multiplicateur (9) à un facteur de calibrage,
- un intégrateur (15) qui est couplé au bloc de calibrage (10) et fournit à sa sortie une valeur de mesure énergétique calibrée (W),
- la mémoire non volatile (12) servant à enregistrer le facteur de calibrage comprenant une multitude de cellules de mémoire (13) programmables de manière irréversible et étant réalisée de manière à ce qu'un changement de programmation de n'importe quelle cellule de mémoire (13) provoque une augmentation du facteur de calibrage.

2. Dispositif selon la revendication 1,
**caractérisé en ce que** la mémoire non volatile (12) comprend une entrée de programmation (14) pour la programmation de la cellule de mémoire programmable (12).

3. Dispositif selon la revendication 1 ou 2,
**caractérisé en ce que**
les cellules de mémoire programmables (12) comprennent chacune une diode, lesquelles diodes, par sollicitation au moyen d'une impulsion énergétique, passent irréversiblement d'un état de conduction fortement ohmique à un état de conduction faiblement ohmique.

4. Dispositif selon la revendication 1 ou 2,
**caractérisé en ce que**
les cellules de mémoire programmables (12) comprennent chacune un coupe-circuits à fusible, lesquels courts-circuits à fusible, par sollicitation au moyen d'une impulsion énergétique, passent irréversiblement d'un état de conduction faiblement ohmique à un état de conduction fortement ohmique.

5. Dispositif selon l'une quelconque des revendications 1 à 4,
**caractérisé en ce que**,
à la sortie de l'intégrateur (15) est raccordé un générateur d'impulsions (16) qui fournit un signal de sortie codé proportionnellement à la valeur de mesure énergétique calibrée (W).

6. Dispositif selon l'une quelconque des revendications 1 à 5,
**caractérisé en ce que**,
pour le couplage de la première et de la deuxième entrée (2, 3) au multiplicateur (9), il est prévu à chaque fois un transducteur analogique/numérique (5, 6).

7. Dispositif selon la revendication 6,
**caractérisé en ce que**,
pour le couplage du transducteur analogique/numérique (5, 6) au multiplicateur (9), il est prévu à chaque fois un filtre numérique (7, 8) qui est relié côté entrée à une sortie du transducteur analogique/numérique (5, 6) et côté sortie à chaque fois à une entrée du multiplicateur (9).

8. Dispositif selon l'une quelconque des revendications 1 à 7,
**caractérisé en ce que**
la mémoire non volatile (12) est conçue pour y enregistrer le facteur de calibrage sous forme codée en binaire.

9. Dispositif selon l'une quelconque des revendications 1 à 8,
**caractérisé en ce que**
ce dispositif est réalisé sous forme d'un circuit intégré.

10. Dispositif selon l'une quelconque des revendications 1 à 9,
**caractérisé en ce que**
la mémoire non volatile (12) est réalisée de manière à ce que le facteur de calibrage déductible dans la mémoire non volatile (12) puisse prendre exclusivement des valeurs positives.
